# EUROPÄISCHE PATENTSCHRIFT

(11) **EP 0 894 270 B1**
(45) Veröffentlichungstag und Bekanntmachung des Hinweises auf die Patenterteilung: **09.08.2006**
(21) Anmeldenummer: 97944703.4
(22) Anmeldetag: 12.09.1997
(51) Int. Cl.: G01R 27/14, B60R 21/16, B60R 16/02

(54) **VERFAHREN ZUM MESSEN DES WIDERSTANDES EINER AN EINEM DREHÜBERTRAGER ANGESCHLOSSENEN LAST**
METHOD FOR MEASURING RESISTANCE OF A LOAD CONNECTED TO A ROTATION TRANSFORMER
PROCEDE PERMETTANT DE MESURER LA RESISTANCE D'UNE CHARGE RELIEE A UN ORGANE DE TRANSMISSION DE ROTATION

(30) Priorität: 13.02.1997 DE 19705430
(43) Veröffentlichungstag der Anmeldung: 03.02.1999
(73) Patentinhaber: ROBERT BOSCH GMBH, 70442 Stuttgart (DE)
(72) Erfinder: MATTES, Bernhard, D-74343 Sachsenheim (DE); SCHUMACHER, Hartmut, D-71691 Freiberg (DE); HENNE, Ralf, D-74321 Bietigheim-Bissingen (DE)
(86) Internationale Anmeldenummer: PCT/DE1997/002041
(87) Internationale Veröffentlichungsnummer: WO 1998/036285

(56) Entgegenhaltungen:
- EP-A- 0 337 171
- DE-A- 3 334 240
- DE-A- 4 432 301

## Beschreibung

### Stand der Technik

Die vorliegende Erfindung betrifft ein Verfahren zum Messen des Widerstandes einer an einem Drehübertrager sekundärseitig angeschlossenen Last - vorzugsweise der Zündpille eines Airbags - durch Auswertung einer an der Primärseite des Übertragers erfaßbaren elektrischen Größe.

Eine derartige Anordung ist aus der DE 38 12 633 A1 bekannt. Gemäß diesem Stand der Technik wird beispielsweise zur Signalübertragung zwischen einem Steuergerät und einem in einem Lenkrad eines Fahrzeugs eingebauten Airbag ein Drehübertrager verwendet. Um die Funktionsfähigkeit eines Airbags ständig zu überprüfen, damit er in jeder Notfallsituation sofort einsatzbereit ist, wird der Widerstand der Zündpille, der im Bereich von z. B. 1,8 Ω bis 2,5 Ω liegen soll, einer ständig wiederkehrenden Messung unterzogen. Die Übertragung von Signalen mittels der induktiv gekoppelten Wicklungen des Drehübertragers ist vom Abstand der beiden Wicklungen, d. h. der Größe des Luftspalts zwischen den Schalenkernen der Wicklungen, abhängig. Einbau- und Fertigungstoleranzen des Lenkrades, an dem der sekundärseitige Schalenkern des Drehübertragers installiert ist, können zu einer Verfälschung des gemessenen Widerstandes der Zündpille führen. Um solche Meßsignalverfälschungen zu vermeiden, sieht der genannte Stand der Technik einen Schwingkreis auf der Sekundärseite des Drehübertragers vor, der von der Primärseite aus von einem Steuersignal angeregt wird. Nach Abschalten des Steuersignals wird das abklingende Antwortsignal des Schwingkreises auf die Primärseite zurückübertragen und aus der Zeitkonstanten des abklingenden Antwortsignals der sekundärseitige Widerstand ermittelt. Der sekundärseitig gemessene Widerstand hängt bei dieser Meßmethode sehr stark vom Radial- und Axialspiel zwischen der Primär- und der Sekundärwicklung des Drehübertragers ab. Die Genauigkeit, mit der der Zündpillenwiderstand gemessen wird, ist also nicht sehr hoch.

Aus DE 44 32 301 A1 ist es bekannt, mittels Entlade- und Aufladevorgängen eines Kondensators den Widerstand und die Kapazität eines Zündelements für eine Wechselspannungszündung zu messen. Dabei wird einer ersten Messung der Widerstand des Zündelements und in einer zweiten Messung die Kapazität des Zündelements bestimmt.

Der Erfindung liegt daher die Aufgabe zugrunde, ein Verfahren der eingangs genannten Art anzugeben, mit der eine an der Sekundärseite eines Drehübertragers angeschlossene Last mit möglichst hoher Genauigkeit gemessen werden kann.

### Vorteile der Erfindung

Die genannte Aufgabe wird gemäß den Merkmalen des Anspruchs 1 dadurch gelöst, daß zunächst ein in den Primärkreis des Übertragers eingefügter Kondensator aufgeladen wird, und daß in einem ersten Entladevorgang der Kondensator für eine vorgegebene Zeitspanne über den Übertrager teilentladen wird und danach die Restladespannung des Kondensators ermittelt wird. Dann wird der Kondensator wieder aufgeladen und anschließend in einem zweiten Entladevorgang mit einer Pulsfolge stufenweise über den Übertrager teilentladen. Danach wird wiederum die Restladespannung des Kondensators ermittelt. Schließlich wird die Differenz aus den beiden Restladespannungen nach dem ersten und zweiten Entladevorgang gebildet, welche ein Maß für den Widerstand der Zündpille darstellt. Durch die Differenzbildung der beiden Restladespannungen werden Temperatureinflüsse und Einflüsse des Radial- und Axialspiels zwischen den beiden Wicklungen des Drehübertragers gegenseitig kompensiert, so daß die Differenzspannung weitestgehend nur noch von dem tatsächlichen Widerstand der Zündpille abhängt.

Gemäß den Unteransprüchen entspricht die Pulsfolgefrequenz, mit der der Kondensator entladen wird, in etwa der Resonanzfrequenz des Resonanzkreises, der im wesentlichen aus der Induktivität des Übertragers und der Kapazität des Kondensators gebildet wird.

Die nach einer vollständigen Aufladung des Kondensators an ihm abfallende Spannung kann mit einem Sollwert verglichen werden, wobei eine Abweichung der gemessenen Spannung von dem Sollwert auf einen Kurzschluß an den primärseitigen Anschlüssen des Übertragers oder auf einen Isolationsfehler des Kondensators hinweist.

Aus einer nach einer vorgegebenen Ladezeit des Kondensators erreichten Ladespannung kann ein Meßwert für die Kapazität des Kondensators abgeleitet werden.
Eine Anordung zur Durchführung des erfindungsgemäßen Verfahrens besteht darin, daß über elektronische Schalter die Anschlüsse der mit einem Kondensator beschalteten Primärwicklung des Übertragers an einen Ladekreis oder an einen Entladekreis schaltbar sind, daß sowohl im Ladekreis als auch im Entladekreis über einen Spannungsteiler eine der am Kondensator anliegenden Spannung proportionale Spannung abgreifbar ist und daß eine Schaltungseinheit vorhanden ist, welche die Differenz zwischen den nach zwei Entladevorgängen abgegriffenen Restladespannungen ermittelt.

### Beschreibung eines Ausführungsbeispiels

Anhand eines in der Zeichnung dargestellten Ausführungsbeispiels wird nachfolgend die Erfindung näher erläutert. Es zeigen:
Figur 1 ein Schaltbild zum Messen des Widerstandes einer sekundärseitig an einen Drehübertrager angeschlossenen Last, Figur 2 ein Zeitdiagramm einiger in der Schaltung nach Fig.1 auftretender Signale und
Figur 3 ein Ablaufdiagramm für das Verfahren zur Widerstandsmessung.

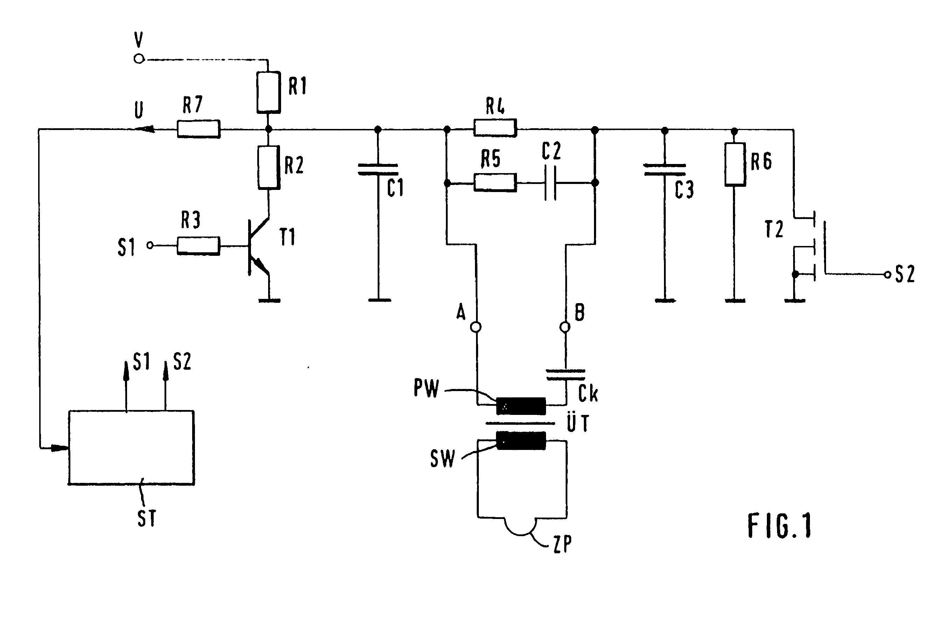

In der Figur 1 ist ein Übertrager ÜT dargestellt, dessen Primärwicklung PW und Sekundärwicklung SW um eine gemeinsame Achse gegeneinander verdrehbar sind. An die Sekundärwicklung SW ist eine Last angeschlossen, beispielsweise die Zündpille ZP für einen Airbag oder einen Gurtstraffer. In Reihe mit der Primärwicklung PW ist ein Kondensator Ck geschaltet. An die Klemmen A und B der Primärwicklung PW des Drehübertragers ÜT schließt sich eine Schaltung an, mit der der Widerstand der Zündpille ZP gemessen werden kann. Die Kondensatoren C1 und C3 dienen dazu, Hochfrequenzstörungen zu bedämpfen. Der parallel zu den Klemmen A und B geschaltete Widerstand R5 und der Kondensator C2 bilden ein Dämpfungsglied, um Ausschwingvorgänge während der Diagnose der Zündpille ZP zu unterdrücken und damit Hochfrequenz-Abstrahlungen zu minimieren. Über einen Spannungsteiler R1, R4 und R6 kann der Kondensator Ck über eine Spannung V aufgeladen werden. Weiterhin sind zwei elektronische Schalter T1 und T2, vorzugsweise Transistoren, vorhanden. Über den elektronischen Schalter T2 kann durch ein Steuersignal S2 die Klemme B an Masse gelegt werden. Wird der elektronische Schalter T1 von einem Steuersignal S1 über den Widerstand R3 angesteuert, während die Klemme B an Masse liegt, kommt es zu einer Entladung des Kondensators Ck über den Drehübertrager ÜT und den Widerstand R2. Während des Aufladevorganges kann eine der Ladespannung des Kondensators Ck proportionale Spannung U am Spannungsteiler R7, R1, R4, R6 abgegriffen werden. Nach dem Entladevorgang ist die der Restladespannung am Kondensator Ck proportionale Spannung U über den Spannungsteiler R7 abgreifbar. In einer Schaltungseinheit ST können aus der Spannung U der Widerstandswert der Zündpille ZP und auch andere Diagnosewerte über den an die Klemmen A und B angeschlossenen Zündkreis hergeleitet werden.

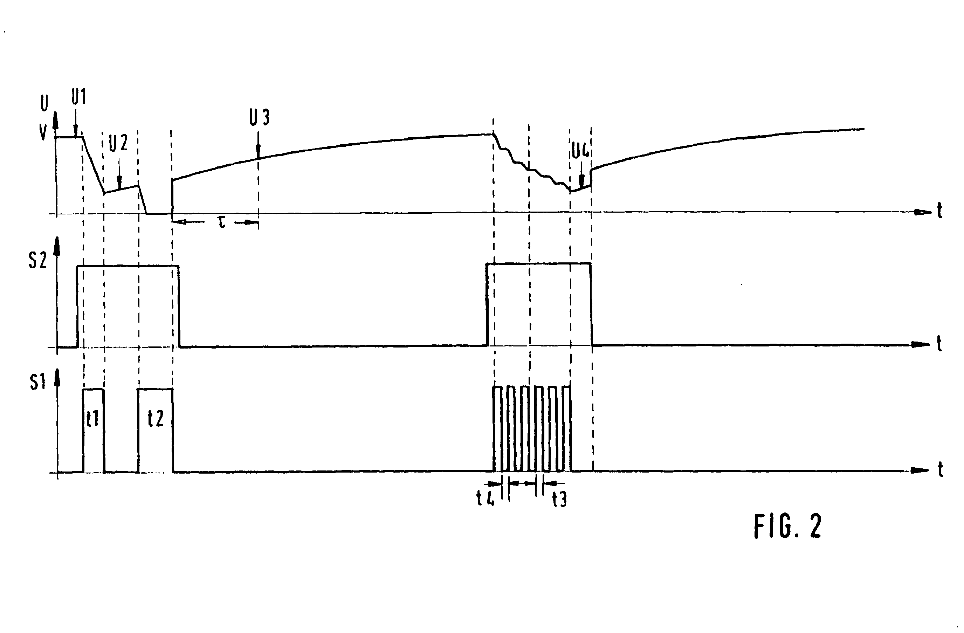

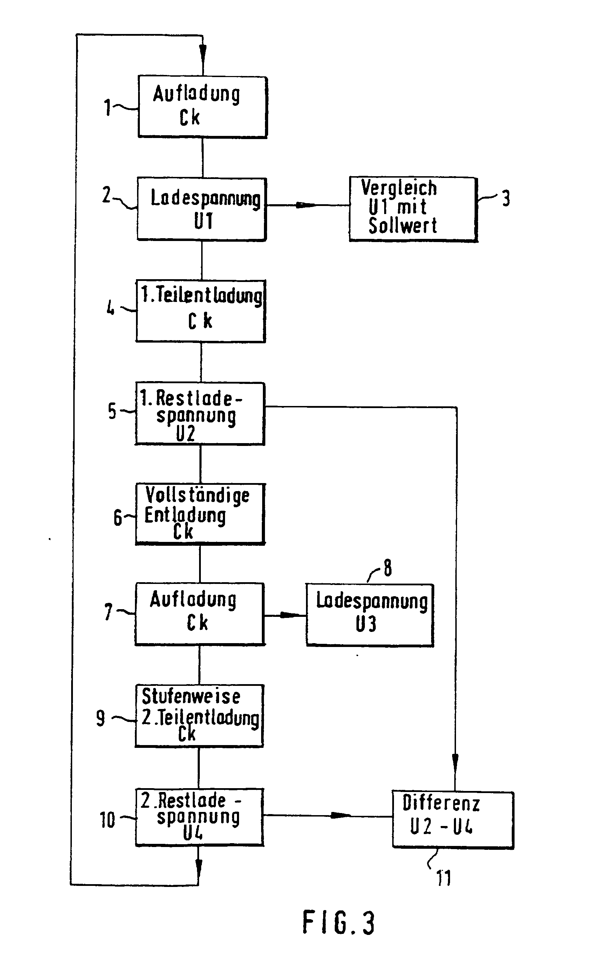

Anhand des in der Figur 3 dargestellten Ablaufdiagramms und dem in Figur 2 dargestellten Zeitdiagramm der Steuersignale S1, S2 und der Spannung U wird der Betrieb der in Figur 1 gezeigten Diagnoseschaltung beschrieben. Gesteuert von der Schaltungseinheit ST wird im ersten Verfahrensschritt 1 die Spannung V über den Spannungsteiler R1, R4, R6 sowie den Übertrager ÜT an den Kondensator Ck angelegt, um diesen vollständig aufzuladen. Am Ende des Ladevorgangs hat die Spannung U, wie der Figur 2 zu entnehmen ist, den Wert U1 erreicht. Im Verfahrensschritt 2 wird diese Ladespannung U1 gemessen und der Schaltungseinheit ST zugeführt. Ob die Klemme A oder B gegen die Batteriespannung oder Masse einen Kurzschluß aufweist oder einen Nebenschluß zwischen den Klemmen A und B besteht oder ein Isolationsfehler des Kondensators Ck vorliegt, kann in der Schaltungseinheit ST anhand der gemessenen Ladespannung U1 festgestellt werden. Dazu wird im Verfahrensschritt 3 die Ladespannung U1 mit einem Sollwert verglichen. Weicht die gemessene Spannung U1 um ein gewisses Maß von dem Sollwert ab, dann kann davon ausgegangen werden, daß einer der genannten Fehler vorliegt.

Im Verfahrensschritt 4 wird eine erste Teilentladung des Kondensators Ck vorgenommen. Dazu wird der elektronische Schalter T2 durch Anlegen des Steuersignals S2 geschlossen, wodurch die Klemme B an Masse gelegt wird. Wenige Mikrosekunden danach wird das Steuersignal S1 für eine Zeit t1 (ca. 25 Mikrosekunden) an den elektronischen Schalter T1 angelegt, um diesen zu schließen. Dadurch wird der Kondensator Ck über den Widerstand R2 und den Übertrager ÜT teilweise entladen. Wird nach der Zeit t1 der Schalter T1 wieder geöffnet, wird im Verfahrensschritt 5 die dann noch am Kondensator Ck anliegende Restspannung U = U2 gemessen und in der Schaltungseinheit ST festgehalten. Nach dem Öffnen des Schalters T1 muß eine kurze Einschwingzeit abgewartet werden, bevor die Restladespannung U2 gemessen werden kann. Wieweit der Kondensator Ck entladen wird und wie groß damit die gemessene Restladespannung U2 ist, ist abhängig von der Entladezeit t1, dem Widerstand R2, der ohmschen Last ZP an der Sekundärwicklung SW des Übertragers ÜT und der magnetischen Kopplung zwischen der Primärwicklung PW und der Sekundärwicklung SW. Die Ansteuerzeit t1 des Schalter T1 ist so zu wählen, daß die Entladung des Kondensators Ck in möglichst weiten Grenzen durch die Veränderung des Widerstandes der Zündpille ZP beeinfluß wird. Die gemessene Spannung U2 ist um so größer, je größer der Widerstand der Zündpille ZP und je größer der Abstand zwischen der Primärwicklung PW und der Sekundärwicklung SW ist. Eine klare Trennung zwischen dem Einfluß des Widerstandes der Zündpille ZP und dem Einfluß des Abstandes zwischen den Wicklungen PW und SW ist mit dieser Messung noch nicht möglich.

Im Verfahrensschritt 6 wird der Kondensator Ck dadurch vollständig entladen, daß das Steuersignal S1 für eine Zeit t2 (ca. 50 Mikrosekunden) den Schalter T1 schließt. Nachdem der Schalter T1 wieder geöffnet ist, wird auch das Steuersignal S2 zurückgenommen, so daß auch der Schalter T2 öffnet. Die Folge davon ist, daß ein neuer Ladevorgang des Kondensators Ck einsetzt (Verfahrensschritt 7). Im Verfahrensschritt 8 wird nach einer vorgegebenen Ladezeit T die Ladespannung U = U3 gemessen. Diese Ladespannung U3 ist ein Maß für die Kapazität des Kondensators Ck. Damit läßt sich diagnostizieren, ob der Kondensator Ck im Primärkreis des Drehübertragers ÜT fehlerbehaftet ist.

Der Spannungsteiler R1, R4, R6 ist so zu wählen, daß die Aufladung des Kondensators Ck im Verfahrensschritt 7 im Bereich weniger Millisekunden liegt, damit im Verfahrensschritt 9 eine zweite Teilentladung des Kondensators Ck in einem möglichst geringen zeitlichen Abstand nach der ersten Teilentladung durchgeführt werden kann.

Wie schon bei der ersten Teilentladung wird nun auch bei der zweiten Teilentladung das Steuersignal S2 an den elektronischen Schalter T2 gelegt, um diesen zu schließen, so daß die Anschlußklemme B des Übertragers ÜT an Masse gelegt ist. Wenige Mikrosekunden danach wird das Steuersignal S1 an den elektronischen Schalter T1 gelegt. Das Steuersignal S1 ist jetzt eine Pulsfolge (z.B. 6 Pulse) bei der die Pulsdauer z.B. 6 Mikrosekunden und die Pulspause auch 6 Mikrosekunden beträgt. Die Pulsfolgefrequenz entspricht in etwa der Resonanzfrequenz des Resonanzkreises, der im wesentlichen aus der Induktivität des Übertragers ÜT und der Kapazität des Kondensators Ck besteht. Durch die pulsartige Ansteuerung des Schalters T1 kommt es zu einer stufenweisen Entladung des Kondensators Ck. Nach dem letzten Impuls der Steuerspannung S1 wird gemäß Verfahrensschritt 10 die am Kondensator Ck vorhandene zweite Restladespannung U=U4 gemessen und in der Schaltungseinheit ST festgehalten. Die Größe der Entladung des Kondensators Ck und damit die gemessene Spannung U4 ist abhängig von dem Widerstand R2, der Zahl der Entladeimpulse, deren Pulsdauer t3 und Pulspause t4 sowie von der ohmschen Last ZP an der Sekundärwicklung SW des Übertragers ÜT und der magnetischen Kopplung zwischen der Primärwicklung PW und der Sekundärwicklung SW. Die Entladepulsrate ist so zu wählen, daß die Entladung des Kondensators Ck in möglichst weiten Grenzen durch die Veränderung des Zündpillenwiderstandes ZP beeinflußt wird. Die Restladespannung U4 am Kondensator Ck ist um so kleiner, je größer der Widerstand der Zündpille ZP ist, und die Spannung U4 ist um so größer, je größer der Abstand, d. h. je kleiner die Kopplung, zwischen der Primärwicklung PW und der Sekundärwicklung SW des Übertragers ÜT ist.

Im Verfahrensschritt 11 wird schließlich die Differenzspannung UD zwischen den beiden Restladespannungen U2 und U4 nach der ersten und der zweiten Teilentladung des Kondensators Ck berechnet. Wie die Gleichungen (1) und (2) der beiden Restladespannungen U2 und U4 zeigen, geht der Widerstand der Zündpille ZP bei den beiden Restladespannungen mit unterschiedlichen Vorzeichen ein, so daß sich bei einer Subtraktion der beiden Restladespannungen U2 und U4 die Einflüsse des Zündpillenwiderstandes ZP addieren. Da aber die Restladespannungen U2 und U4 in gleicher Weise vom Abstand, d. h. der Kopplung zwischen der Primärwicklung und der Sekundärwicklung des Übertragers und auch von Temperatureinflüssen abhängen, kompensieren sich diese Störeinflüsse bei der Subtraktion der beiden Restladespannungen U2 und U4. Man erhält also eine Differenzspannung UD = U2-U4, die ein Maß für den Zündpillenwiderstand ZP darstellt, welches weitgehend unbeeinflußt von Schwankungen der magnetischen Kopplung des Übertragers ÜT und von Temperatureinflüssen ist.

## Patentansprüche

1. Verfahren zum Messen des Widerstandes einer an einem Drehübertrager sekundärseitig angeschlossenen ohmschen Last - nämlich der Zündpille eines Airbags - durch Auswertung einer an der Primärseite des Übertragers erfassbaren elektrischen Größe, **dadurch gekennzeichnet,**
- **dass** ein in den Primärkreis des Übertragers (ÜT) eingefügter Kondensator (Ck) aufgeladen wird,
- **dass** in einem ersten Entladevorgang der Kondensator (Ck) für eine vorgegebene Zeitspanne über den Übertrager (ÜT) teilentladen wird und danach die Restladespannung (LT2) des Kondensators (Ck) ermittelt wird,
- **dass** dann der Kondensator (Ck) wieder aufgeladen wird,
- **dass** anschließend in einem zweiten Entladevorgang der Kondensator (Ck) mit einer Pulsfolge stufenweise über den Übertrager (ÜT) teilentladen wird und danach die Restladespannung (U4) des Kondensators (Ck) ermittelt wird
- und **dass** die Differenz aus den Restladespannungen (U2, U4) nach dem ersten und dem zweiten Entladevorgang gebildet wird, welche ein Maß für den Widerstand der sekundärseitig angeschlossenen Last (ZP) darstellt.

2. Verfahren nach Anspruch 1, **dadurch gekennzeichnet, dass** die nach einer vollständigen Aufladung des Kondensators (Ck) an ihm abfallende Spannung (U1) mit einem Sollwert verglichen wird, wobei eine Abweichung der gemessenen Spannung (U1) von dem Sollwert auf einen Kurzschluss an den primärseitigen Anschlüssen (A, B) des Übertragers (ÜT) oder auf einen Isolationsfehler des Kondensators (Ck) hinweist.

3. Verfahren nach Anspruch 1, **dadurch gekennzeichnet, dass** die nach einer vorgegebenen Ladezeit des Kondensators (Ck) erreichte Ladespannung (U3) ermittelt wird, welche ein Maß für die Kapazität des Kondensators (Ck) ist.

4. Verfahren nach Anspruch 1, **dadurch gekennzeichnet, dass** die Pulsfolgefrequenz in etwa der Resonanzfrequenz des Resonanzkreises entspricht, der im wesentlichen aus der Induktivität des Übertragers (ÜT) und der Kapazität des Kondensators (Ck) gebildet wird.

5. Anordnung zur Durchführung des Verfahrens nach einem der vorhergehenden Ansprüche, **dadurch gekennzeichnet, dass** über elektronische Schalter (T1, T2) die Anschlüsse (A, B) der mit einem Kondensator (Ck) beschalteten Primärwicklung (PW) des Übertragers (ÜT) an einen Ladekreis (R1, R4, R6) oder an einen Entladekreis (R2, ÜT, ZP) schaltbar sind, dass sowohl im Ladekreis (R1, R4, R6) als auch im Entladekreis (R2, ÜT, ZP) über einen Spannungsteiler (R2, R4) eine der am Kondensator (Ck) anliegenden Spannung proportionale Spannung (U) abgreifbar ist und dass eine Schaltungseinheit (ST) vorhanden ist, welche die Differenz zwischen den nach zwei Entladevorgängen abgegriffenen Restladespannungen (U2, U4) ermittelt.

## Claims

1. Method for measuring the resistance of a resistive load - namely the firing cap of an airbag - which is connected to the secondary of a rotary transformer, by evaluating an electrical variable which can be detected on the primary of the transformer, **characterized**
- **in that** a capacitor (Ck) which is inserted into the primary circuit of the transformer (ÜT) is charged,
- **in that** the capacitor (Ck) is partially discharged by means of the transformer (ÜT) for a prespecified period of time in a first discharge process, and the residual charge voltage (U2) of the capacitor (Ck) is then determined,
- **in that** the capacitor (Ck) is then charged again,
- **in that** the capacitor (Ck) is subsequently partially discharged with a pulse train in stages by means of the transformer (ÜT) in a second discharge process, and the residual charge voltage (U4) of the capacitor (Ck) is then determined,
- and **in that** the difference between the residual charge voltages (U2, U4) following the first and the second discharge processes is formed, this difference constituting a measure of the resistance of the load (ZP) which is connected to the secondary.

2. Method according to Claim 1, **characterized in that** the voltage (U1) which is dropped across the capacitor (Ck) following complete charging of the said capacitor is compared with a setpoint value, with a deviation of the measured voltage (U1) from the setpoint value indicating a short circuit at the primary connections (A, B) of the transformer (ÜT) or an insulation fault in the capacitor (Ck).

3. Method according to Claim 1, **characterized in that** the charge voltage (U3) which is achieved following a prespecified charging time of the capacitor (Ck) is determined, this charge voltage being a measure of the capacitance of the capacitor (Ck).

4. Method according to Claim 1, **characterized in that** the pulse repetition frequency corresponds approximately to the resonant frequency of the resonant circuit which is formed essentially from the inductance of the transformer (ÜT) and the capacitance of the capacitor (Ck).

5. Arrangement for carrying out the method according to one of the preceding claims, **characterized in that** the connections (A, B) of the primary winding (PW), which is connected to a capacitor (Ck), of the transformer (ÜT) can be connected to a charging circuit (R1, R4, R6) or to a discharge circuit (R2, ÜT, ZP) by means of electronic switches (T1, T2), **in that** both in the charging circuit (R1, R4, R6) and in the discharge circuit (R2, ÜT, ZP) a voltage (U) which is proportional to the voltage on the capacitor (Ck) can be tapped off across a voltage divider (R2, R4), and **in that** there is a circuit unit (ST) which determines the difference between the residual charge voltages (U2, U4) which are tapped off following two discharge processes.

## Revendications

1. Procédé permettant de mesurer la résistance d'une charge ohmique reliée du côté secondaire à un transformateur rotatif - à savoir de la pastille de déclenchement d'un airbag - par évaluation d'une grandeur électrique détectable du côté primaire du transformateur,
**caractérisé en ce que**
- on charge un condensateur (Ck) inséré dans le circuit primaire du transformateur (ÜT),
- dans une première opération de décharge, on décharge partiellement le condensateur (Ck) par le transformateur (ÜT) pendant une durée prédéterminée et on détermine ensuite la tension de charge résiduelle (U2) du condensateur (Ck),
- on charge de nouveau le condensateur (Ck),
- dans une deuxième opération de décharge, on décharge ensuite partiellement le condensateur (Ck) par le transformateur (ÜT) par paliers avec une suite d'impulsions et on détermine ensuite la tension de charge résiduelle (U4) du condensateur (Ck), et
- on forme la différence entre les tensions de charge résiduelles (U2, U4) après la première et la deuxième opération de décharge, différence qui représente une mesure de la résistance de la charge (ZP) reliée du côté secondaire.

2. Procédé selon la revendication 1,
**caractérisé en ce qu'**
on compare la tension (U1) qui diminue au condensateur (Ck) après une première charge totale de celui-ci avec une valeur de consigne, et un écart de la tension mesurée (U1) par rapport à la valeur de consigne signale un court-circuit aux bornes primaires (A, B) du transformateur (ÜT) ou un défaut d'isolation du condensateur (Ck).

3. Procédé selon la revendication 1,
**caractérisé en ce qu'**
on détermine la tension de charge (U3) atteinte après une durée de charge prédéterminée du condensateur (Ck), qui est une mesure de la capacité du condensateur (Ck).

4. Procédé selon la revendication 1,
**caractérisé en ce que**
la fréquence de la suite d'impulsions correspond sensiblement à la fréquence de résonance du circuit de résonance, formé essentiellement par l'inductance du transformateur (ÜT) et la capacité du condensateur (Ck).

5. Dispositif pour la mise en oeuvre du procédé selon l'une quelconque des revendications précédentes,
**caractérisé en ce que**
les bornes (A, B) de l'enroulement primaire (PW) du transformateur (ÜT) muni du condensateur (Ck) peuvent être reliées par des interrupteurs électroniques (T1, T2) à un circuit de charge (R1, R4, R6) ou à un circuit de décharge (R2, ÜT, ZP), une tension (U) proportionnelle à la tension présente au condensateur (Ck) peut être mesurée aussi bien dans le circuit de charge (R1, R4, R6) que dans le circuit de décharge (R2, ÜT, ZP), et il comprend une unité de commutation (ST) qui détermine la différence entre les tensions de charge résiduelles (U2, U4) mesurées après deux opérations de décharge.
